# EUROPÄISCHE PATENTANMELDUNG

(11) **EP 2 882 268 A1**
(43) Veröffentlichungstag der Anmeldung: **10.06.2015**
(21) Anmeldenummer: 13195859.7
(22) Anmeldetag: 05.12.2013
(51) Int. Cl.: H05K 3/28, H05K 5/02, H05K 7/20

(54) **Schutz von Elektronik**

(71) Anmelder: Taurob GmbH, 1230 Wien (AT)
(72) Erfinder: Silberbauer, Lukas-Sebastian, 2380 Perchtoldsdorf (AT)

(57) **Zusammenfassung**

Bei einem Verfahren zum Schützen einer elektrischen oder elektronischen Baugruppe gegen Umwelteinflüsse, wird vorgeschlagen, dass in einem Herstellungsschritt eines Schutzmantels für die Baugruppe eine Separationsschicht auf die Baugruppe aufgebracht wird, dass anschließend auf der Separationsschicht eine Vergussmasse aufgebracht wird, und dass die zweite Schicht nach dem Aushärten eine im Wesentlichen zerstörungsfrei abnehmbare harte Schale ausbildet.

## Beschreibung

Die Erfindung betrifft ein Verfahren zum Schützen einer elektrischen oder elektronischen Baugruppe gegen Umwelteinflüsse gemäß dem Oberbegriff des Anspruches 1.

Elektrische oder elektronische Baugruppen sind häufig widrigen Umgebungsbedingungen ausgesetzt, vor denen sie geschützt werden müssen. Diese Bedingungen beinhalten Feuchtigkeit, welche zu Korrosion führen kann, mechanische Schocks und Schläge, Vibration, elektrostatische Entladungen durch schlechte Handhabung und Temperaturschwankungen.

Ein bekanntes Verfahren zum Schutz von Elektronik ist der Verguss. Dabei wird eine Schicht aus Vergussmasse auf die Baugruppe, beispielsweise eine Leiterplatte, aufgebracht, wodurch, die sich auf der Leiterplatte befindlichen Bauelemente, fixiert und umhüllt werden. Diese Methode hat den Vorteil, dass die resultierende Baugruppe mechanisch sehr robust ist, die Wärmeleitung verbessert wird, und einwirkende Medien von empfindlichen Bauteilen zuverlässig ferngehalten werden können.

Dieses Verfahren hat jedoch den Nachteil, dass sich der Verguss nur sehr aufwendig, und meistens überhaupt nicht, von der Leiterplatte und den Bauelementen zerstörungsfrei wieder lösen lässt. Dadurch können defekte Bauteile nicht mit einfachen Mitteln getauscht werden, Fehlerbilder analysiert oder Test- und Programmiermethoden angewendet werden, welche einen direkten Zugang zu einzelnen Bauelementen erfordern.

Aufgabe der Erfindung ist es daher, ein Verfahren zum Schützen einer elektrischen oder elektronischen Baugruppe gegen Umwelteinflüsse anzugeben, mit welchem die genannten Nachteile vermieden werden können, und die elektrische oder elektronische Baugruppe gut gegen Umwelteinflüsse geschützt wird und trotzdem leicht zu warten bleibt.

Erfindungsgemäß wird dies durch die Merkmale des Anspruches 1 erreicht.

Durch die hier beschriebene Erfindung ergibt sich der Vorteil, dass elektrische und elektronische Baugruppen durch Verguss umfassend geschützt werden können, wobei es leicht möglich ist, den Verguss rückstandsfrei zu entfernen und auch teilweise wiederzuverwenden. Dies führt, besonders in der Prototypenphase einer Entwicklung, zu erheblichen Zeit- und Kostenersparnissen, da mit herkömmlichen Vergussmethoden die Schaltungen beim Auftreten eines Fehlers häufig komplett ersetzt werden müssen. Das einfache Entfernen der durch die Vergussmasse gebildeten Schale erlaubt es hier, fehlerhafte Bauteile rasch zu lokalisieren und zu tauschen. Dies ist besonders vorteilhaft bei elektrischen Sicherungen und Verschleißteilen wie nicht-flüchtige Speicher mit begrenzter Anzahl von Schreibzyklen oder Pufferbatterien. Darüber hinaus können Programmierstecker, welche im Normalbetrieb nicht gebraucht werden, zuverlässig geschützt werden. Wenn sich zu einem späteren Zeitpunkt die Firmware des jeweiligen Bauteils ändert, ist es möglich, diese mithilfe des freigelegten Programmiersteckers zu aktualisieren.

Weiters betrifft das Verfahren eine elektrische oder elektronische Baugruppe gemäß dem Oberbegriff des Patentanspruches 10.

Aufgabe der Erfindung ist es daher weiters eine elektrische oder elektronische Baugruppe anzugeben, welche gut gegen Umwelteinflüsse geschützt ist und trotzdem leicht zu warten bleibt.

Erfindungsgemäß wird dies durch die Merkmale des Anspruches 9 erreicht.

Dadurch ergeben sich die vorstehenden Vorteile.

Die Unteransprüche betreffen weitere vorteilhafte Ausgestaltungen der Erfindung.

Ausdrücklich wird hiermit auf den Wortlaut der Ansprüche Bezug genommen, wodurch die Ansprüche an dieser Stelle durch Bezugnahme in die Beschreibung eingefügt sind und als wörtlich wiedergegeben gelten.

Vorgesehen ist ein Verfahren zum Schützen einer elektrischen oder elektronischen Baugruppe gegen Umwelteinflüsse. Die elektrische oder elektronische Baugruppe kann insbesondere eine Schaltung, eine mit elektronischen Bauelementen bestückte Leiterplatte, ein Aktuator, ein Sensor, eine Anzeigevorrichtung, eine Batterie oder ein Akkumulator sein.

Hierbei ist vorgesehen, dass in einem Herstellungsschritt eines Schutzmantels für die Baugruppe eine Separationsschicht auf die Baugruppe aufgebracht wird, dass anschließend auf der Separationsschicht eine Vergussmasse aufgebracht wird, und dass die zweite Schicht nach dem Aushärten eine im Wesentlichen zerstörungsfrei abnehmbare harte Schale ausbildet.

Dadurch ergibt sich der Vorteil, dass eine Baugruppe beispielsweise vor mechanischen, thermischen oder korrosiven Einwirkungen zuverlässig geschützt werden kann, jedoch weiterhin wartbar bleibt. So ist es nach Abnehmen der Schale möglich, Bauteile zu überprüfen und zu tauschen, elektronische Verbindungen zu Testpunkten oder Programmierschnittstellen aufzubauen oder Einstellungen an veränderbaren Bauteilen, zum Beispiel Potentiometern oder Spulen, vorzunehmen. Weiters ergibt sich der Vorteil, dass die ausgehärtete Schale nach dem Abnehmen wiederverwendet werden kann, wobei es zulässig ist, die Schale beim ersten Abnehmen geringfügig, beispielsweise durch kleine Schnitte, anzupassen.

Vorteilhaft ist, wenn die Baugruppe hinterschneidungsfrei ist, sodass die Vergussmasse keine Teile hintergreift und dadurch abnehmbar bleibt.

Besonders bevorzugt kann vorgesehen sein, dass im Fall einer nicht hinterschneidungsfreien Baugruppe eine Separationsschicht oder Vergussmasse mit einer Viskosität größer als 10⁵ mPa • s im nicht ausgehärteten Zustand verwendet wird, welche nicht unter Bauteile läuft.

Die Separationsschicht kann beispielsweise die gesamte Baugruppe oder nur Teile davon umschließen. Die Vergussmasse kann wiederum die gesamte Separationsschicht oder nur Teile davon umschließen.

Weiters ist eine elektrische oder elektronische Baugruppe vorgesehen, wobei die Baugruppe durch diesen Schutzmantel vor Umwelteinflüssen geschützt ist.

Insbesondere kann vorgesehen sein, dass für die Separationsschicht eine erste Schicht durch ein Überziehen der Baugruppe mit Lack, Kunststoff oder Gummi ausgebildet wird.

Als Separationsschicht kann beispielsweise eine hochflexible Gummibeschichtung, wie sie unter dem Warenzeichen Plasti Dip, von der Firma Plasti Dip International erhältlich ist, vorzugsweise in mehreren Lagen aufgetragen werden. Dadurch ergibt sich der Vorteil, dass die Separationsschicht nach der Aushärtung im Wartungsfall wie eine Folie von der Baugruppe abgezogen werden kann. Alternativ kann Acrylschutzlack für die Separationsschicht verwendet werden. Dieser hat den Vorteil, dass er sich mittels Lösungsmitteln leicht entfernen lässt. Die Separationsschicht kann beispielsweise als Korrosionsschutz, Abstandshalter oder zur Vergleichmäßigung der Oberfläche wirken.

Besonders bevorzugt kann vorgesehen sein, dass die Separationsschicht eine Schicht eines Trennmittels umfasst. Als Trennmittel eignet sich vorzugsweise Wachs oder ein anderes Formtrennmittel, welches beispielsweise auf die Separationsschicht aufgetragen werden kann. Es wird im Wartungsfall gemeinsam mit Separationsschicht entfernt und muss danach nicht mehr aufgetragen werden.

Bevorzugt kann weiters vorgesehen sein, dass die Separationsschicht mit einer Dicke zwischen 25 µm und 250 µm aufgebracht wird. Dadurch ergibt sich ein guter Schutz vor Korrosion bei gleichzeitig guter thermischer Kopplung zwischen Baugruppe und Vergussmasse.

Besonders bevorzugt kann vorgesehen sein, dass als Vergussmasse vergießbarer Kunststoff oder Harz verwendet wird. Beispielsweise kann hier eine Vergussmasse auf Polyurethan-Basis verwendet werden. Dadurch ergibt sich der Vorteil, dass es zu einer geringen Volumensschwindung beim Aushärten kommt und die ausgehärtete Schale aufgrund der elastischen Eigenschaften des Polyurethans leichter abgenommen werden kann. Alternativ kann beispielsweise auch eine Vergussmasse auf Epoxidharz-Basis verwendet werden.

Bevorzugt kann vorgesehen sein, dass vor dem Aufbringen der Vergussmasse Befestigungsmittel an der Baugruppe angebracht werden, und dass die Befestigungsmittel von der Vergussmasse umgossen werden. Ein solches Befestigungsmittel kann beispielsweise ein Leiterplattenpfosten aus Nylon sein, welcher sich in einem Loch in der Leiterplatte verspreizt. Dadurch ergibt sich der Vorteil, dass die durch die Vergussmasse gebildete harte Schale mechanisch an der Leiterplatte fixiert wird und trotzdem abnehmbar bleibt.

Besonders bevorzugt kann vorgesehen sein, dass während des Aufbringens der Vergussmasse Montagehilfen an der Außenseite der Vergussmasse angebracht werden, und dass die Montagehilfen von der Vergussmasse umgossen werden. Eine solche Montagehilfe kann beispielsweise eine einfache Schraube sein, deren Kopf durch die Vergussmasse umschlossen, und damit fixiert wird, und deren Schaft nach außen durch die Vergussmasse hindurch ragt. Dadurch ergibt sich der Vorteil, dass die Baugruppe leicht an einem Rahmen befestigt werden kann.

Besonders bevorzugt kann weiters vorgesehen sein, dass während des Aufbringens der Vergussmasse eine Oberfläche einer Außenseite der Vergussmasse mittels einer Vergussform vergrößert wird. Eine besonders vorteilhafte Ausführung dieser Variante ist das Gießen von Kühlrippen. Durch diese Oberflächenvergrößerung ergibt sich der Vorteil, dass von der Baugruppe abgestrahlte thermische Energie leichter nach außen abgegeben werden kann. Dadurch kann dieses Verfahren auch zum Schützen von Leistungselektronik angewendet werden.

Bevorzugt kann außerdem vorgesehen sein, dass in einem Wartungsschritt die durch die Vergussmasse gebildete Schale abgenommen wird, dass durch entfernen der Separationsschicht die Baugruppe freigelegt wird und manipuliert werden kann, dass eine Korrosionsschutzschicht auf die Baugruppe aufgebracht wird, und dass die Schale auf die Korrosionsschutzschicht aufgesetzt wird. Die Korrosionsschutzschicht kann dabei andere Eigenschaften als die Separationsschicht aufweisen, da die Schale bereits ausgehärtet ist. So kann die Korrosionsschutzschicht beispielsweise aus einem sprühfähigem Acryllack mit niedriger Viskosität bestehen, welcher leichter aufzutragen ist. Zusätzlich kann in diesem Fall auf das Trennmittel verzichtet werden.

Vorgesehen ist außerdem eine elektrische oder elektronische Baugruppe die durch einen Schutzmantel nach einem Verfahren nach einem der Ansprüche 1 bis 9 vor Umwelteinflüssen geschützt ist.

## Patentansprüche

1. Verfahren zum Schützen einer elektrischen oder elektronischen Baugruppe gegen Umwelteinflüsse, **dadurch gekennzeichnet, dass** in einem Herstellungsschritt eines Schutzmantels für die Baugruppe eine Separationsschicht auf die Baugruppe aufgebracht wird, dass anschließend auf der Separationsschicht eine Vergussmasse aufgebracht wird, und dass die zweite Schicht nach dem Aushärten eine im Wesentlichen zerstörungsfrei abnehmbare harte Schale ausbildet.

2. Verfahren nach Anspruch 1, **dadurch gekennzeichnet, dass** für die Separationsschicht eine erste Schicht durch ein Überziehen der Baugruppe mit Lack, Kunststoff oder Gummi ausgebildet wird.

3. Verfahren nach Anspruch 1 oder 2, **dadurch gekennzeichnet, dass** die Separationsschicht eine Schicht eines Trennmittels umfasst.

4. Verfahren nach einem der Ansprüche 1 bis 3, **dadurch gekennzeichnet, dass** die Separationsschicht mit einer Dicke zwischen 25 µm und 250 µm aufgebracht wird.

5. Verfahren nach einem der Ansprüche 1 bis 4, **dadurch gekennzeichnet, dass** als Vergussmasse vergießbarer Kunststoff oder Harz verwendet wird.

6. Verfahren nach einem der Ansprüche 1 bis 5, **dadurch gekennzeichnet, dass** vor dem Aufbringen der Vergussmasse Befestigungsmittel an der Baugruppe angebracht werden, und dass die Befestigungsmittel von der Vergussmasse umgossen werden.

7. Verfahren nach einem der Ansprüche 1 bis 6, **dadurch gekennzeichnet, dass** während des Aufbringens der Vergussmasse Montagehilfen an der Außenseite der Vergussmasse angebracht werden, und dass die Montagehilfen von der Vergussmasse umgossen werden.

8. Verfahren nach einem der Ansprüche 1 bis 7, **dadurch gekennzeichnet, dass** während des Aufbringens der Vergussmasse eine Oberfläche einer Außenseite der Vergussmasse mittels einer Vergussform vergrößert wird.

9. Verfahren nach einem der Ansprüche 1 bis 8, **dadurch gekennzeichnet, dass** in einem Wartungsschritt die durch die Vergussmasse gebildete Schale abgenommen wird, dass durch entfernen der Separationsschicht die Baugruppe freigelegt wird und manipuliert werden kann, dass eine Korrosionsschutzschicht auf die Baugruppe aufgebracht wird, und dass die Schale auf die Korrosionsschutzschicht aufgesetzt wird.

10. Elektrische oder elektronische Baugruppe, **dadurch gekennzeichnet**, die Baugruppe durch einen Schutzmantel nach einem Verfahren nach einem der Ansprüche 1 bis 9 vor Umwelteinflüssen geschützt ist.
